# EUROPÄISCHE PATENTSCHRIFT

(11) **EP 0 705 438 B1**
(45) Veröffentlichungstag und Bekanntmachung des Hinweises auf die Patenterteilung: **17.09.1997**
(21) Anmeldenummer: 94918785.0
(22) Anmeldetag: 26.05.1994
(51) Int. Cl.: G01R 19/252, G01R 35/02, H03F 1/30, H03F 3/70

(54) **MESSVERSTÄRKER**
MEASUREMENT AMPLIFIER
AMPLIFICATEUR DE MESURE

(30) Priorität: 23.06.1993 DE 4320817
(43) Veröffentlichungstag der Anmeldung: 10.04.1996
(73) Patentinhaber: LEYBOLD AKTIENGESELLSCHAFT, 50968 Köln (DE)
(72) Erfinder: ROLFF, Norbert, D-50169 Horrem (DE)
(74) Vertreter: Leineweber, Jürgen, Dipl.-Phys.
(86) Internationale Anmeldenummer: EP9401686
(87) Internationale Veröffentlichungsnummer: WO9500856

(56) Entgegenhaltungen:
- DE-A- 3 322 471
- FR-A- 2 634 559
- US-A- 3 944 920
- US-A- 4 620 148
- US-A- 4 697 151
- INTERNATIONALE ELEKTRONISCHE RUNDSCHAU, Nr.6, 1973, BERLIN DE Seiten 123 - 126 KÜNZEL 'NULLPUNKTFEHLER DES OPERATIONSVERSTÄRKERS'

## Beschreibung

Die Erfindung betrifft einen Meßverstärker nach dem Oberbegriff des Patentanspruchs 1.

Den nächstliegenden Stand der Technik bildet der Inhalt der DE-A-33 22 471. Die US-A-39 44 920 beschreibt ein Gerät zur Messung kleiner Ströme mit einem Integrator. Aus der US-A-46 20 148 ist ein Präzisions-Strommessgerät mit einem Integrator bekannt, dessen Eingang einander kompensierende Ströme zugeführt werden.

Bei der Erfassung sehr kleiner Ströme stellt sich das Problem, dass die Ausgangsspannung der als Integrator arbeitenden Schaltung, z.B. der Operationsverstärker, und des Schalters der Referenzstromquelle, durch einen zeitlich veränderlichen Fehler- oder Leckstrom beeinflusst wird.

Der Erfindung liegt die Aufgabe zugrunde, den Fehlerstrom zu erfassen.

Zur erfindungsgemäßen Erfassung des Fehlerstroms liegt in Reihe mit dem Eingang des Operationsverstärkers ein Kondensator. Ferner ist ein Schaltelement vorgesehen, das in der geschlossenen Stellung den Kondensator überbrückt. Aus der Differenz der bei geschlossenem und geöffnetem Schaltelement am Ausgang des Integrators gemessenen Spannungsänderung kann der Fehlerstrom bestimmt werden. Zur Kompensation des Fehlerstroms ist vorteilhafterweise eine Kompensationsstromquelle vorgesehen, die einen einstellbaren Kompensationsstrom liefert, der an dem Eingang der als Integrator benutzten Schaltung eingespeist wird. Der Kompensationsstrom ist bei korrekter Fehlerstromkompensation so eingestellt, dass die Ausgangsspannungen des als Differentiator arbeitenden Operationsverstärkers bei geschlossenem und geöffnetem Schaltelement gleich sind. Durch Öffnen und Schließen des Schaltelements und durch Veränderung der Größe des Kompensationsstroms kann der Fehlerstrom vollständig kompensiert werden.

Bekannte Ladungsbilanzverstärker, die eine Ausgangsspannung mit einer zu dem Eingangsstrom proportionalen Frequenz liefern, weisen einen Integrator auf, der einen Integrationskondensator enthält. Ferner weisen die bekannten Ladungsbilanzverstärker eine Referenzstromquelle auf. Die Referenzstromquelle speist für eine vorbestimmte Zeit an den Eingangsknoten einen Referenzstrom ein, wenn die sich am Ausgang des Integrators einsstellende Spannung eine Referenzspannung über-/unterschritten hat. Bei eingeschalteter Referenzstromquelle entlädt sich der Kondensator. Die Frequenz, mit der der Auf- und Entladevorgang erfolgt, ist proportional dem Eingangsstrom.

Sofern ein derartiger Ladungsbilanzverstärker zur Messung sehr kleiner Ströme eingesetzt wird, ist die Frequenz sehr niedrig, so dass die Messwerterfassung problematisch ist. Änderungen des zu messenden Eingangsstroms können nicht sofort erfasst werden, da die Zeit des Ladevorgangs bei sehr kleinen Eingangsströmen zu groß ist.

Bei dem erfindungsgemäßen Messwertverstärker ist deshalb ferner eine Schaltung vorgesehen, die die sich am Ausgang des Integrators einstellende Spannung empfängt. Dies kann z.B. ein Differentiator sein. Der Differentiator liefert eine der zeitlichen Änderung der Spannung proportionale Ausgangsspannung. Die Ausgangsspannung des Differentiators ist proportional zu dem zu messenden Eingangsstroms des Messverstärkers. Weiterhin kann die Spannungsänderung auch durch die Messung in mindestens zwei Zeitpunkten erfolgen.

Der erfindungsgemäße Messverstärker erlaubt die Erfassung sehr kleiner Ströme und kann beispielsweise in der Vakuumtechnik zur Messung der von einem Ionisationsvakuummeter gebildeten Ionenströme eingesetzt werden, die in einer Größenordnung ab ca. 10⁻¹⁵ Ampere liegen.

Der Differentiatorausgang wird vorteilhafterweise ausgewertet, wenn die Referenzstromquelle abgeschaltet ist und der Integrationskondensator geladen wird. Aus der zeitlichen Änderung der sich am Ausgang des Integrators einstellenden Spannung kann auf die Größe des Eingangsstromes geschlossen werden. Je größer der Eingangsstrom ist, desto schneller erreicht die Ausgangsspannung des Operationsverstärkers die Referenzspannung.

Bei der Erfassung sehr kleiner Ströme stellt sich ferner das Problem, daß die Ausgangsspannung der als Integrator arbeitenden Schaltung, z.B. der Operationsverstärker, und des Schalters der Referenzstromquelle, durch einen zeitlich veränderlichen Fehler- oder Leckstrom beeinflußt wird. Zur Erfassung des Fehlerstroms kann in Reihe mit dem Eingang des Operationsverstärkers ein Kondensator liegen. Ferner ist ein Schaltelement vorgesehen, das in der geschlossenen Stellung den Kondensator überbrückt. Aus der Differenz der bei geschlossenem und geöffnetem Schaltelement am Ausgang des Integrators gemessenen Spannungsänderung kann der Fehlerstrom bestimmt werden. Zur Kompensation des Fehlerstroms ist vorteilhafterweise eine Kompensationsstromquelle vorgesehen, die einen einstellbaren Kompensationsstrom liefert, der an dem Eingang der als Integrator benutzten Schaltung eingespeist wird. Der Kompensationsstrom ist bei korrekter Fehlerstromkompensation so eingestellt, daß die Ausgangsspannungen des als Differentiator arbeitenden Operationsverstärkers bei geschlossenem und geöffnetem Schaltelement gleich sind. Durch Öffnen und Schließen des Schaltelements und durch Veränderung der Größe des Kompensationsstroms kann der Fehlerstrom vollständig kompensiert werden.

Weiterhin besteht die Möglichkeit, den Fehlerstrom nicht oder nur teilweise zu kompensieren, ihn jedoch zu erfassen und nachträglich zu eliminieren.

Im folgenden werden unter Bezugnahme auf die Zeichnungen ein Ausführungsbeispiel der Erfindung näher erläutert.

Es zeigen:

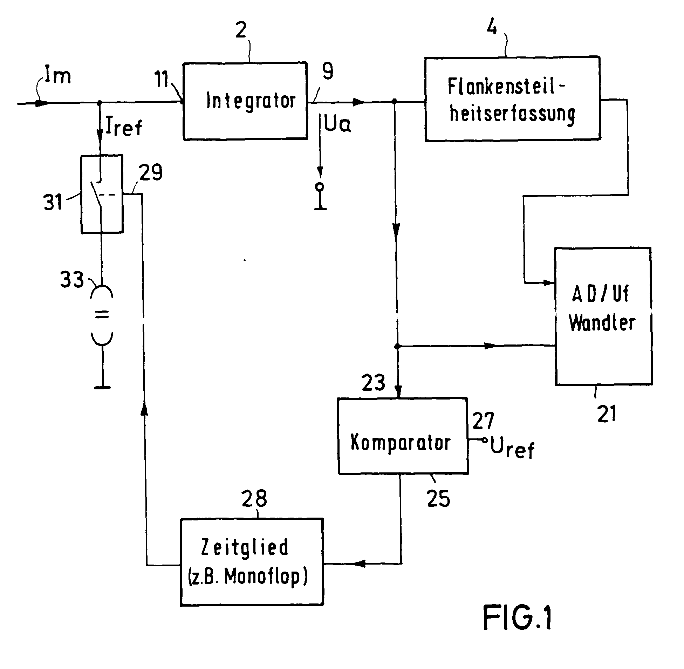

- Fig. 1: das Blockschaltbild des Meßverstärkers,
- Fig. 2: ein Schaltbild des aus einem Integrator und einem nachgeschalteten Differentiator bestehenden Meßverstärkers und
- Fig. 3: die Spannung am Ausgang des als Integrator arbeitenden Operationsverstärkers und der im Rückkopplungszweig fließende Strom als Funktion der Zeit.

Der Meßverstärker besteht aus einem als Integrator arbeitenden Operationsverstärker 1 und einem als Differentiator geschalteten Operationsverstärker 3. Der nichtinvertierende Eingang 5 des Operationsverstärkers 1 liegt an Masse. In dem Rückkopplungszweig zwischen dem invertierenden Eingang 7 und dem Ausgang 9 des Operationsverstärkers liegen zwei in Reihe geschaltete Kondensatoren C₁,C₂, wobei der zu messende Eingangsstrom Iₘ an dem gemeinsamen Verbindungspunkt 11 der beiden Kondensatoren C₁,C₂ eingespeist wird.

Parallel zu dem Kondensator C₂, der zwischen dem Verbindungspunkt 11 und dem invertierenden Eingang 7 des Operationsverstärkers 1 liegt, ist ein Schaltelement 13 geschaltet, das den Kondensator C₂ in der geschlossenen Stellung überbrückt. Der Ausgang 9 des Operationsverstärkers 1 ist über einen Kondensator C₃ mit dem invertierenden Eingang 15 des Operationsverstärkers 3 verbunden. Der nichtinvertierende Eingang 17 des Operationsverstärkers 3 liegt an Masse und der Rückkopplungszweig zwischen dem invertierenden Eingang 15 und dem Ausgang 19 des Operationsverstärkers 3 enthält einen Widerstand R.

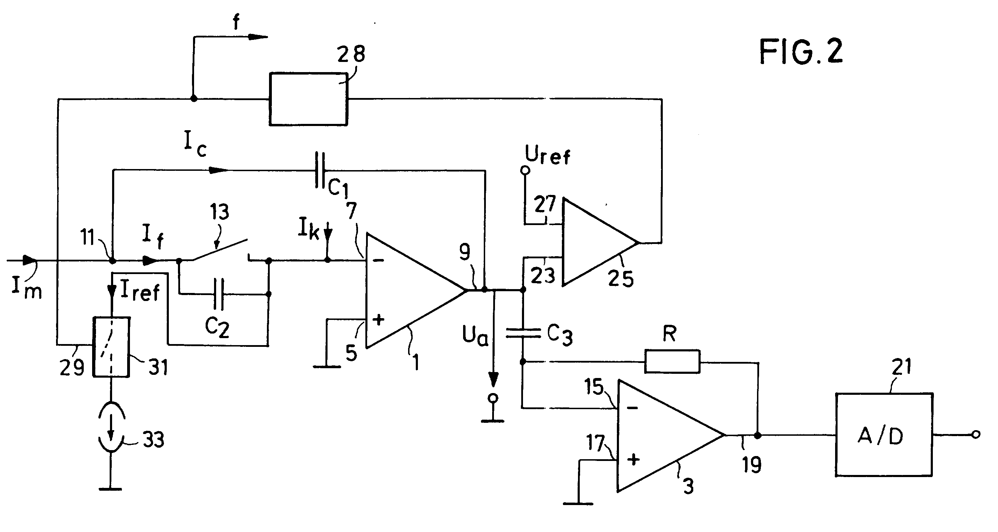

Ferner weist der Meßverstärker einen Analog/Digital-Wandler 21 auf, der das Ausgangssignal des als Differentiator arbeitenden Operationsverstärkers 3 verarbeitet. Der Ausgang des als Integrator 2 arbeitenden Operationsverstärkers 1 ist mit einem Eingang 23 eines Komparators 25 verbunden. An dem anderen Eingang 27 des Komparators 25 liegt eine Referenzspannung U_{ref}, die von einer in Fig. 2 nicht dargestellen Referenzspannungsquelle erzeugt wird. Der Ausgang des Komparators 25 ist über eine zeitbestimmende Stufe, z.B. Monoflop 28, mit einem Steuereingang 29 eines elektronischen Schalters 31 verbunden. In der geschlossenen Schaltstellung verbindet der elektronische Schalter 31 eine Referenzstromquelle 33 mit dem Eingang 7 des Operationsverstärkers 1. Ferner weist der Meßverstärker eine in Fig. 2 nicht dargestellte Kompensationsstromquelle auf, die einen einstellbaren Kompensationsstrom Iₖ liefert, der an dem invertierenden Eingang 7 des Operationsverstärkers 1 eingespeist wird.

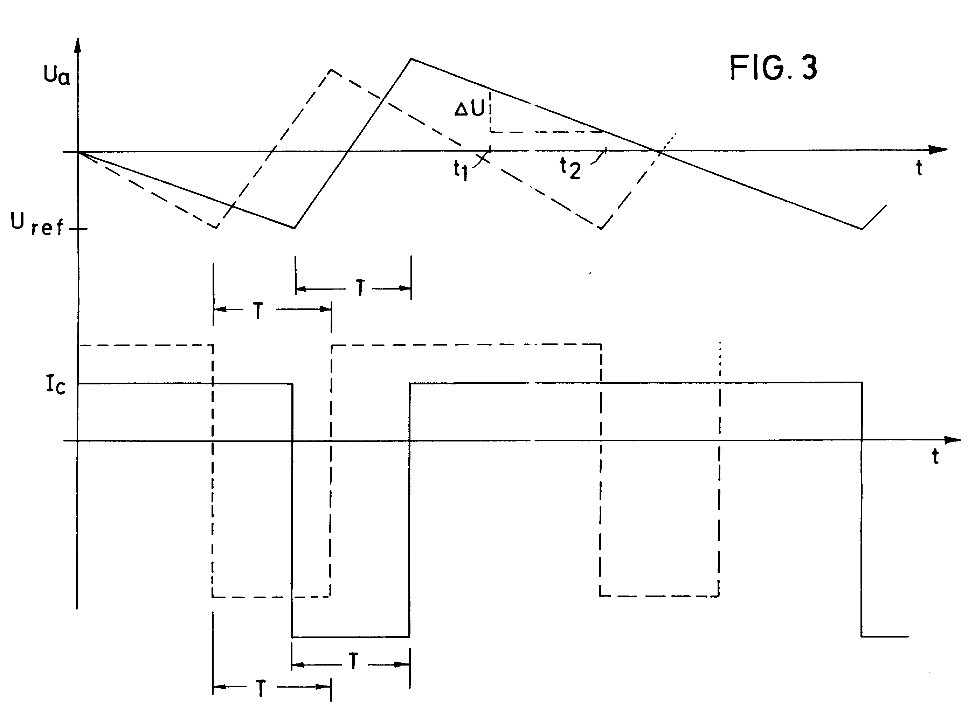

Die Funktionsweise der Schaltung wird im Folgenden anhand von Fig. 3 erläutert.

Es sei angenommen, daß das Schaltelement 13 geschlossen ist und der Fehlerstrom I_{f} und der Kompensationsstrom Iₖ gleich Null sind. Der Strom I_{c} im Rückkopplungszweig entspricht dem zu messenden Eingangsstrom Iₘ. Die Spannung Uₐ am Ausgang 9 des als Integrator arbeitenden Operationsverstärkers 1 nimmt stetig ab. Wenn die Ausgangsspannung gleich der Referenzspannung U_{ref} ist, wird der Ausgang des Komparators 25 positiv und die monostabile Kippstufe wird angesteuert, die für eine vorbestimmte Zeit T ein Steuersignal zum Schließen des elektronischen Schalters 29 erzeugt. Solange sich der elektronische Schalter in der geschlossenen Stellung befindet, fließt der Referenzstrom I_{ref} und der Kondensator C₁ wird, da der Referenzstrom größer als der Eingangsstrom ist, entladen. Nach Ablauf der Verzögerungszeit T öffnet sich der elektronische Schalter 31 wieder und die Referenzstromquelle 33 ist abgeschaltet, so daß ein neuer Ladezyklus beginnt. Die Stromquelle 33 wird mit einem solchen Tastverhältnis gesteuert, daß die Ladungsbilanz Null ist. Die Frequenz der am Ausgang der monostabilen Kippstufe anliegenden Rechteckspannung ist proportional zu dem Eingangsstrom Iₘ und kann mit einem Frequenzzähler gemessen werden.

Für den Fall, daß der Eingangsstrom erhöht wird, verkürzt sich der Ladezyklus des Kondensators C₁, wie in Fig. 3 in gestrichelter Linie dargestellt ist. Je größer der Eingangsstrom ist, desto schneller erreicht die Ausgangsspannung Uₐ des Operationsverstärkers 1 die Referenzspannung U_{ref}. Aus der Spannungsdifferenz _{Δ}U, der sich zu den Zeitpunkten t₁ und t₂ am Ausgang des Operationsverstärkers 1 einstellenden Spannung, kann auf die Größe des Eingangsstroms Iₘ geschlossen werden. Der Differentiator erfaßt die zeitliche Änderung der Spannung während des Ladezyklus und erzeugt eine Ausgangsspannung, die dem Eingangsstrom proportional ist.

Sofern sehr kleine Eingangsströme zu messen sind, wird die Größe des Stroms aus der zeitlichen Änderung der Spannung am Ausgang des Operationsverstärkers 1, d.h. aus dem Differentiator, bestimmt. Bei größeren Eingangsströmen kann die Frequenz der Rechteckspannung am Ausgang der monostabilen Kippstufe 28 direkt gemessen und aus der Frequenz die Größe des Eingangsstroms bestimmt werden.

Die Kompensation des Fehlerstroms I_{f} erfolgt unter der Annahme, daß der Fehlerstrom nicht von den Kondensatoren C₁ und C₂ verursacht wird. Zur Kompensation des Fehlerstroms wird der von der Kompensationsstromquelle gelieferte Kompensationsstrom Iₖ so eingestellt, daß beim öffnen und Schließen des Schaltelements 13 die Ausgangsspannung des Operationsverstärkers 3 gleich bleibt. Stellt sich am Signalausgang sowohl bei geöffnetem als auch bei geschlossenem Schaltelement die gleiche Ausgangsspannung ein, ist der Fehlerstrom kompensiert und die Ausgangsspannung ist nur noch vom Meßstrom Iₘ abhängig. Folglich lassen sich mit dem Meßverstärker auch sehr kleine Ströme mit hoher Genauigkeit messen. Zur Bestimmung des Kompensationsstroms braucht der Eingangsstrom nicht abgeschaltet zu werden, so daß eine Meßwerterfassung auch während des Kompensationsvorgangs möglich ist.

## Patentansprüche

1. Messverstärker mit
einem Ladungsbilanzverstärker bestehend aus einem Integrator (2) mit mindestens einem Kondensator (C₁), und
einer Referenzstromquelle (33), die einen Referenzstrom (I_{ref}) für eine vorbestimmte Zeit (T) an dem Eingang (11) des Integrators (2) einspeist, wenn die sich am Ausgang (9) des Integrators (2) einstellende Spannung (Uₐ) eine Referenzspannung (U_{ref}) über-/unterschritten hat, wobei
eine Schaltung vorgesehen ist, die die sich am Ausgang des Integrators (2) einstellende Spannung (Uₐ) empfängt und eine der zeitlichen Änderung der Spannung proportionale Ausgangsgröße liefert,
dadurch gekennzeichnet, dass ein Kondensator (C₂) in Reihe zu dem Eingang (7) der als Integrator arbeitenden Schaltung liegt, und dass ein parallel zu dem Kondensator (C₂) angeordnetes Schaltelement (13) vorgesehen ist, das den Kondensator in der geschlossenen Stellung überbrückt.

2. Messverstärker nach Anspruch 1, dadurch gekennzeichnet, dass eine Kompensationsstromquelle vorgesehen ist, die einen festen oder einstellbaren Kompensationsstrom (Iₖ) liefert, der an dem invertierenden Eingang (7) der als Integrator arbeitenden Schaltung eingespeist wird.

3. Messverstärker nach Anspruch 2, dadurch gekennzeichnet, dass der Kompensationsstrom (Iₖ) derart eingestellt ist, dass die Spannungen am Ausgang (19) des Operationsverstärkers (3) bei geschlossenem und geöffnetem Schaltelement (13) gleich sind.

4. Messverstärker nach Anspruch 1, 2 oder 3, dadurch gekennzeichnet, dass ein Differentiator (4) die sich am Ausgang des Integrators (2) einstellende Spannung empfängt, wobei die Änderung der Spannung (Uₐ) am Ausgang des Integrators (2) in eine proportionale Spannung umgewandelt wird.

5. Messverstärker nach Anspruch 4, dadurch gekennzeichnet, dass die zeitliche Änderung der Spannung (Uₐ) durch mindestens zwei Messungen der Spannung (Uₐ) am Ausgang des Integrators (2) in zeitlicher Abfolge erfasst wird.

6. Messverstärker nach Anspruch 4, gekennzeichnet durch einen die Ausgangsspannung des Differentiators und/oder die Spannung (Uₐ) am Ausgang des Integrators (2) empfangenden Analog/Digital-Wandler oder Analog/Frequenz-Wandler.

7. Messverstärker nach einem der Ansprüche 1 bis 4, dadurch gekennzeichnet, dass der Integrator aus einem Operationsverstärker (1) mit mindestens einem einen Kondensator (C₁) enthaltenden Gegenkopplungszweig zwischen dem invertierenden Eingang (7) und dem Ausgang (9) besteht.

8. Messverstärker nach einem der Ansprüche 1 bis 7, dadurch gekennzeichnet, dass der Integrator nichtinvertierend aufgebaut ist, wobei der Integrationskondensator (C₁) auf Bezugspotential geschaltet ist.

## Claims

1. A measuring amplifier having a charge balance amplifier comprising an integrator (2) with at least one capacitor (C₁), and a reference current source (33) which feeds-in a reference current (I_{ref}) at the input (11) of the integrator (2) for a predetermined time interval (T) when the voltage (Uₐ) occurring at the output (9) of the integrator (2) has overshot/undershot a reference voltage (U_{ref}), wherein a circuit is provided which receives the voltage (Uₐ) occurring at the output of the integrator (20 and supplies an output variable which is proportional to the change in the voltage as a function of time, characterised in that a capacitor (C₂) is arranged in series with the input (7) of the circuit operating as integrator and that a switching element (13) is provided which is arranged in parallel to the capacitor (C₂) and which bridges the capacitor in the closed position.

2. A measuring amplifier according to Claim 1, characterised in that a compensation current source is provided which supplies a fixed or adjustable compensation current (Iₖ) which is fed-in at the inverting input (7) of the circuit operating as integrator.

3. A measuring amplifier according to Claim 2, characterised in that the compensation current (Iₖ) is set such that the voltages at the output (19) of the operational amplifier (3) are identical when the switching element (13) is closed and open.

4. A measuring amplifier according to Claim 1, 2 or 3, characterised in that a differentiator (4) receives the voltage occurring at the output of the integrator (2), wherein the change in the voltage (Uₐ) at the output of the integrator (2) is converted into a proportional voltage.

5. A measuring amplifier according to Claim 4, characterised in that the change in the voltage (Uₐ) as a function of time is detected by means of at least two measurements of the voltage (Uₐ) at the output of the integrator (2) in a time sequence.

6. A measuring amplifier according to Claim 4, characterised by an analogue/digital converter or analogue/frequency converter which receives the output voltage of the differentiator and/or the voltage (Uₐ) at the output of the integrator (2).

7. A measuring amplifier according to one of Claims 1 to 4, characterised in that the integrator comprises an operational amplifier (1) with at least one negative feedback arm, which contains a capacitor (C₁), between the inverting input (7) and the output (9).

8. A measuring amplifier according to one of Claims 1 to 7, characterised in that the integrator is constructed so as to be non-inverting, wherein the integration capacitor (C₁) is connected to reference potential.

## Revendications

1. Amplificateur de mesure équipé
d'un amplificateur d'équilibrage de charge se composant d'un intégrateur (2) avec au moins un condensateur (C₁), et
d'une source de courant de référence (33), qui délivre un courant de référence (I_{ref}) pendant un temps prédéterminé (T) à l'entrée (11) de l'intégrateur (2), lorsque la tension (Uₐ) s'établissant à la sortie (9) de l'intégrateur (2) est passée au-dessus/au-dessous d'une tension de référence (U_{ref}),
un circuit étant prévu qui reçoit la tension (Uₐ) s'établissant à la sortie de l'intégrateur (2) et délivre une grandeur de sortie proportionnelle à la variation temporelle de la tension,
caractérisé en ce qu'un condensateur (T₂) est disposé en série à l'entré (7) du circuit opérant en tant qu'intégrateur, et en ce qu'un élément de commutation (13) disposé en parallèle sur le condensateur (C₂) est prévu, qui shunte le condensateur dans la position fermée.

2. Amplificateur de mesure selon la revendication 1, caractérisé en ce qu'une source de courant de compensation est prévue qui délivre un courant de compensation (Iₖ) fixe ou réglable, qui est appliqué à l'entrée avec inversion (7) du circuit opérant en tant qu'intégrateur.

3. Amplificateur de mesure selon la revendication 2, caractérisé en ce que le courant de compensation (Iₖ) est réglé de sorte que les tensions à la sortie (19) de l'amplificateur opérationnel (3) sont identiques dans le cas de l'élément de commutation (13) fermé et ouvert.

4. Amplificateur de mesure selon la revendication 1, 2 ou 3, caractérisé en ce qu'un différentiateur (4) reçoit la tension s'établissant à la sortie de l'intégrateur (2), la variation de la tension (Uₐ) à la sortie de l'intégrateur (2) étant convertie en une tension proportionnelle.

5. Amplificateur de mesure selon la revendication 4, caractérisé en ce que la variation temporelle de la tension (Uₐ) est obtenue par au moins deux mesures de la tension (Uₐ) à la sortie de l'intégrateur (2) en succession temporelle.

6. Amplificateur de mesure selon la revendication 4, caractérisé par un convertisseur analogique/numérique ou analogique/fréquence recevant la tension de sortie du différentiateur et/ou la tension (Uₐ) à la sortie de l'intégrateur (2).

7. Amplificateur de mesure selon l'une quelconque des revendications 1 à 4, caractérisé en ce que l'intégrateur se compose d'un amplificateur opérationnel (1) avec au moins une branche de contre-réaction contenant un condensateur (C₁) entre l'entrée avec inversion (7) et la sortie (9).

8. Amplificateur de mesure selon l'une quelconque des revendications 1 à 7, caractérisé en ce que l'intégrateur est réalisé sans inversion, le condensateur d'intégration (C₁) étant relié au potentiel de référence.
